# EUROPEAN PATENT APPLICATION

(11) **EP 2 348 538 A2**
(43) Date of publication of application: **27.07.2011**
(21) Application number: 10165098.4
(22) Date of filing: 07.06.2010
(51) Int. Cl.: H01L 31/0224, H01L 31/048, H01L 31/052, H01L 27/142

(54) **Solar cell and method for manufacturing the same**

(30) Priority: 22.01.2010 KR 20100005903
(71) Applicant: Jusung Engineering Co. Ltd., Gyeonggi-Do 464-892 Gwangju-Si (KR)
(72) Inventor: Kim, Tae Hoon, 446-724, Gyeonggi-do (KR); Kang, Dong Young, 449-853, Gyeonggi-do (KR)
(74) Representative: Epping, Wilhelm

(57) **Abstract**

A solar cell capable of improving cell efficiency, and a method for manufacturing the same is disclosed, the solar cell comprising a substrate; a first electrode on the substrate; a photoelectric conversion portion on the first electrode; a second electrode on the photoelectric conversion portion; and plural beads on the second electrode.

## Description

### CROSS REFERENCE TO RELATED APPLICATIONS

This application claims the benefit of the Korean Patent Application No. P2010-0005903 filed on January 22, 2010, which is hereby incorporated by reference as if fully set forth herein.

### BACKGROUND OF THE INVENTION

### Field of the Invention

The present invention relates to a solar cell, and more particularly, to a solar cell capable of improving cell efficiency, and a method for manufacturing the same.

### Discussion of the Related Art

A solar cell with a property of semiconductor converts a light energy into an electric energy.

A structure and principle of the solar cell according to the related art will be briefly explained as follows. The solar cell is formed in a PN-junction structure where a positive(P)-type semiconductor makes a junction with a negative(N)-type semiconductor. When solar ray is incident on the solar cell with the PN-junction structure, holes (+) and electrons (-) are generated in the semiconductor owing to the energy of the solar ray. By an electric field generated in a PN-junction area, the holes (+) are drifted toward the P-type semiconductor and the electrons (-) are drifted toward the N-type semiconductor, whereby an electric power is produced with an occurrence of electric potential.

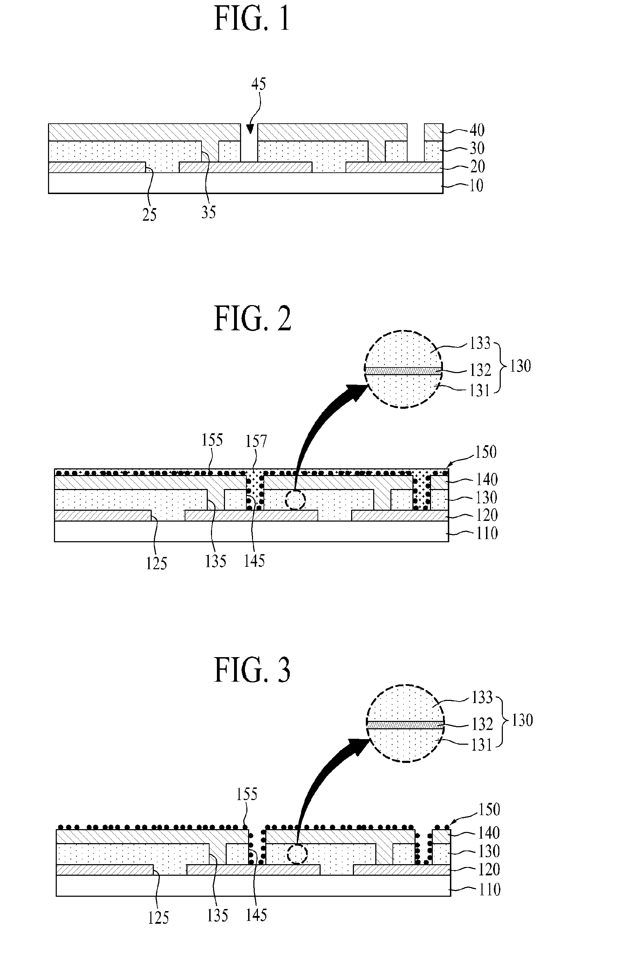

FIG. 1 is a cross section view illustrating a related art solar cell.

Referring to FIG. 1, the related art solar cell includes a substrate 10, a first electrode 20, an electrode-separating portion 25, a photoelectric conversion portion 30, a contact portion 35, a second electrode 40, and a cell-separating portion 45.

The first electrode 20 is formed of a first conductive material, wherein the electrode-separating portion 25 is interposed between each of the plural patterns of the first electrode 20, to thereby form plural patterns of the first electrode 20.

At this time, the electrode-separating portion 25 is formed by removing a predetermined portion of the first electrode 20 through a laser-scribing process, whereby the plural patterns of the first electrode 20 are provided at fixed intervals by the electrode-separating portion 25.

The photoelectric conversion portion 30 is formed on the second electrode 20 and cell-separating portions 25, and is divided into plural patterns thereof by the contact portion 35 on the first electrode 20. At this time, the contact portion 35 is formed by removing a predetermined portion of the photoelectric conversion portion 30 on the first electrode 20 through a laser-scribing process. The photoelectric conversion portion 30 produces electric power based on a smooth drift of electron and hole by an electric field which occurs according to incident solar ray.

The second electrode 40 is formed of a second conductive material. Also, the second electrode 40 is divided into plural patterns thereof by the sell-separating portion 45 on the first electrode 20, and is simultaneously formed on the photoelectric conversion portion 30 and contact portion 35 while being electrically connected to the first electrode 20 through the contact portion 35, whereby neighboring unit cells of the solar cell are connected in series. At this time, the cell-separating portion 45 is formed by removing predetermined portions of the photoelectric conversion portion 30 and second electrode 40 on the first electrode 20 through a laser-scribing process.

For improving the cell efficiency of the solar cell according to the related art, a propagation path length of the incident solar ray has to be increased in the aforementioned photoelectric conversion portion 40 so as to increase occurrence of the electron and hole in the photoelectric conversion portion 40.

However, the solar cell according to the related art is disadvantageous in that it is impossible to increase the propagation path length of the incident solar ray in the photoelectric conversion portion 40. As a result, it is difficult to realize the desired cell efficiency.

### SUMMARY OF THE INVENTION

Accordingly, the present invention is directed to a solar cell and a method for manufacturing the same that substantially obviates one or more problems due to limitations and disadvantages of the related art.

An object of the present invention is to provide a solar cell capable of improving cell efficiency, and a method for manufacturing the same.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, there is provided a solar cell comprising: a substrate; a first electrode on the substrate; a photoelectric conversion portion on the first electrode; a second electrode on the photoelectric conversion portion; and plural beads on the second electrode.

In another aspect of the present invention, there is provided a method for manufacturing a solar cell comprising: forming a first electrode on a substrate; forming a photoelectric conversion portion on the first electrode; forming a second electrode on the photoelectric conversion portion; and forming plural beads on the second electrode.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a cross section view illustrating a related art solar cell;

FIG. 2 is a cross section view illustrating one type of solar cell according to the first embodiment of the present invention;

FIG. 3 is a cross section view illustrating another type of solar cell according to the first embodiment of the present invention;

FIG. 4 illustrates a bead according to one embodiment of the present invention;

FIG. 5 illustrates a bead according to another embodiment of the present invention;

FIG. 6 illustrates a bead according to another embodiment of the present invention;

FIG. 7 is a cross section view illustrating a solar cell according to the second embodiment of the present invention;

FIG. 8 is a cross section view illustrating a solar cell according to the third embodiment of the present invention;

FIG. 9 is a cross section view illustrating a solar cell according to the fourth embodiment of the present invention;

FIG. 10 is a cross section view illustrating one type of solar cell according to the fifth embodiment of the present invention;

FIG. 11 is a cross section view illustrating another type of solar cell according to the fifth embodiment of the present invention;

FIG. 12 is a series of cross section views illustrating a method for manufacturing a solar cell according to the first embodiment of the present invention;

FIG. 13 is a series of cross section views illustrating a method for manufacturing a solar cell according to the second embodiment of the present invention;

FIG. 14 is a series of cross section views illustrating a method for manufacturing a solar cell according to the third embodiment of the present invention;

FIG. 15 is a series of cross section views illustrating a method for manufacturing a solar cell according to the fourth embodiment of the present invention; and

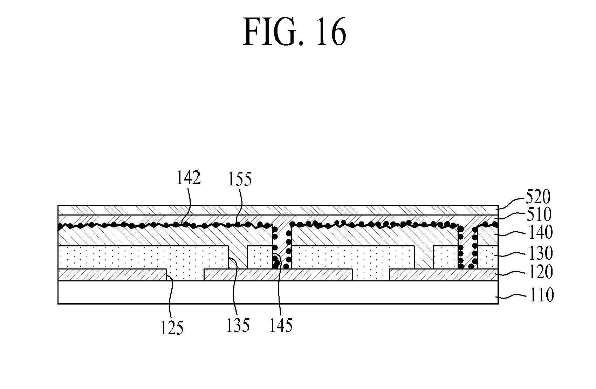

FIG. 16 is a cross section view illustrating an additional process in a method for manufacturing a solar cell according to the fourth embodiment of the present invention.

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

Hereinafter, a solar cell according to the present invention and a method for manufacturing the same will be described with reference to the accompanying drawings.

### SOLAR CELL

FIG. 2 is a cross section view illustrating a solar cell according to the first embodiment of the present invention.

Referring to FIG. 2, the solar cell according to the first embodiment of the present invention includes a substrate 110, a first electrode 120, an electrode-separating portion 125, a photoelectric conversion portion 130, a contact portion 135, a second electrode 140, a cell-separating portion 145, and a light-scattering layer 150.

The substrate 110 is a flexible substrate. If needed, the substrate 110 may be formed of glass or transparent plastic.

The flexible substrate may be formed of polyethyleneterephthalate(PET), polyimide(PI), or polyamide(PA). A flexible solar cell using the flexible substrate can be manufactured in a roll-to-roll method, to thereby lower a manufacturing cost.

The first electrode 120 is formed of a first conductive material on an entire surface of the substrate 110, and is divided into plural patterns by the electrode-separating portion 125. That is, plural patterns of the first electrode 120 are provided at fixed intervals under the circumstance the electrode-separating portion 125 is interposed between each of the plural patterns of the first electrode 120. The first electrode 120 is formed of the first conductive material, for example, metal materials such as Ag, A1, Ag+Mo, Ag+Ni, and Ag+Cu. The first electrode 120 reflects incident solar ray to the photoelectric conversion portion 130.

The electrode-separating portion 125 is formed by removing a predetermined portion from the first electrode 120 through a laser-scribing process, whereby the plural patterns of the first electrode 120 are provided at fixed intervals.

The photoelectric conversion portion 130 is formed on the plural patterns of the first electrode 120 and electrode-separating portions 120, and is divided into plural patterns of the photoelectric conversion portion 130 by the contact portion 135 interposed in-between. That is, the plural patterns of the photoelectric conversion portion 130 are provided at fixed intervals under the circumstance the contact portion 135 is interposed between each of the plural patterns of the photoelectric conversion portion 130. The photoelectric conversion portion 130 produces electric power based on a smooth drift of electron and hole by an electric field which occurs according to the incident solar ray.

The photoelectric conversion portion 130 may be formed of a silicon-based semiconductor material, or a compound such as CIGS (CuInGaSe2). At this time, the photoelectric conversion portion 130 may be formed in an NIP structure wherein N(negative)-type semiconductor layer, I(intrinsic)-type semiconductor layer, and P(positive)-type semiconductor layer are deposited in sequence.

The N-type semiconductor layer indicates a semiconductor layer doped with N-type doping material such as group V elements in the periodic table, for example, stibium (Sb), arsenic (As), and phosphorous (P); the I-type semiconductor layer indicates an intrinsic semiconductor layer; and the P-type semiconductor layer indicates a semiconductor layer doped with P-type doping material such as group III elements in the periodic table, for example, boron (B), gallium (Ga), and indium (In). Instead of the I-type semiconductor layer, another N-type or P-type semiconductor layer which is relatively thinner than the aforementioned N-type or P-type semiconductor layer may be formed; or another N-type or P-type semiconductor layer whose doping concentration is lower than the aforementioned N-type or P-type semiconductor layer may be formed.

In the photoelectric conversion portion 130 with the NIP structure, depletion is generated in the I-type semiconductor layer by the P-type semiconductor layer and the N-type semiconductor layer, whereby an electric field occurs therein. Thus, electrons and holes generated by the solar ray are drifted by the electric field, and the drifted electrons and holes are collected in the N-type semiconductor layer and the P-type semiconductor layer, respectively.

If forming the photoelectric conversion portion 130 with the NIP structure, the N-type semiconductor layer is formed on the first electrode 120, and then the I-type and P-type semiconductor layers are formed thereon, preferably. This is because a drift mobility of the hole is less than a drift mobility of the electron. In order to maximize the efficiency in collection of the incident solar ray, the P-type semiconductor layer is provided adjacent to a light-incidence face.

As known from an expanded part of FIG. 2, the photoelectric conversion portion 130 may be formed in a tandem structure in which a first photoelectric conversion layer 131, a buffer layer 132, and a second photoelectric conversion layer 133 are deposited in sequence.

Both the first and second photoelectric conversion layers 131 and 133 may be formed in an NIP structure wherein N(negative)-type semiconductor layer, I(intrinsic)-type semiconductor layer, and P(positive)-type semiconductor layer are deposited in sequence. Instead of the I-type semiconductor layer, another N-type or P-type semiconductor layer which is relatively thinner than the aforementioned N-type or P-type semiconductor layer may be formed; or another N-type or P-type semiconductor layer whose doping concentration is lower than the aforementioned N-type or P-type semiconductor layer may be formed.

The first photoelectric conversion layer 131 may be formed in the NIP structure of amorphous semiconductor material; and the second photoelectric conversion layer 133 may be formed in the NIP structure of microcrystalline semiconductor material.

The amorphous semiconductor material is characterized by absorption of short-wavelength light; and the microcrystalline semiconductor material is characterized by absorption of long-wavelength light. A mixture of the amorphous semiconductor material and the microcrystalline semiconductor material can enhance light-absorbing efficiency, but it is not limited to this type of mixture. That is, the first photoelectric conversion layer 131 may be made of amorphous semiconductor/germanium material, or microcrystalline semiconductor material; and the second photoelectric conversion layer 133 may be made of amorphous semiconductor material, amorphous semiconductor/germanium material, or microcrystalline semiconductor material.

The buffer layer 132 is interposed between the first and second photoelectric conversion layers 131 and 133, wherein the buffer layer 132 enables a smooth drift of electron and hole by a tunnel junction. The buffer layer 132 may be formed of a transparent material, for example, ZnO, ZnO doped with group III elements in the periodic table (for example, ZnO:B or ZnO:A1), ZnO comprising hydrogen elements (for example, ZnO:H), SnO₂, SnO₂:F, or ITO (Indium-Tin-Oxide).

In addition to the aforementioned tandem structure, the photoelectric conversion portion 130 may be formed in a triple structure. In this triple structure, each buffer layer is interposed between each of first, second and third photoelectric conversion layers included in the photoelectric conversion portion 130.

The contact portion 135 is formed by removing a predetermined portion of the photoelectric conversion portion 130 on the first electrode 120 through a laser-scribing process, whereby the plural patterns of the photoelectric electric portion 130 are provided at fixed intervals.

The second electrode 140 is formed of a second conductive material. The second electrode 140 is divided into plural patterns of the second electrode 140 by the cell-separating portion 145 on the first electrode 120, and is also formed on the photoelectric conversion portion 130 and contact portion 135 while being electrically connected to the first electrode 120 through the contact portion 135, whereby neighboring unit cells of the solar cell are connected in series.

The second electrode 140 is formed on a light-incidence face. The second electrode 140 is formed of the second conductive material of transparent material, for example, ZnO, ZnO doped with group III elements in the periodic table (for example, ZnO:B, ZnO:Al), ZnO comprising hydrogen elements (for example, ZnO:H), SnO₂, SnO₂:F, or ITO (Indium-Tin-Oxide).

The cell-separating portion 145 is formed by removing predetermined portions from the photoelectric conversion portion 130 and second electrode on the first electrode 120 through a laser-scribing process, whereby neighboring unit cells of the solar cell are provided at fixed intervals.

The light-scattering layer 140 includes plural beads 155 coated on the cell-separating portion 145 and second electrode 140. Owing to the plural beads 155, the incident solar ray scatters in all directions, to thereby result in the increased propagation path of the incident solar ray in the photoelectric conversion portion 130. At this time, a haze ratio is determined based on refraction and density of the beads 155, which is adjusted to be within 10 ∼ 70%, preferably.

The light-scattering layer 150 including the plural beads 155 may be formed through steps of preparing a paste by uniformly or ununiformly distributing the plural beads 155 in a binder 157; and coating the prepared paste on the second electrode 140 and cell-separating portion 145. This paste-coating process may be carried out by a printing method, a spray-coating method, a sol-gel method, a dip-coating method, or a spin-coating method.

Preferably, on formation of the light-scattering layer 150, the plural beads 155 are formed through the aforementioned method, and then an additional hardening (or curing) process of ultraviolet-ray hardening process or low-temperature/high-temperature hardening process is carried out, to thereby enhance an adhesive strength among the beads 155.

When forming the light-scattering layer 150, the binder 157 enhances the adhesive strength among the plural beads 155 provided on the second electrode 140 and inside the cell-separating portion 145 through the hardening process, but it is not limited to this. As shown in FIG. 3, the binder 157 may be removed by the hardening process, whereby only the beads 155 may be adhered on the upper surface of the second electrode 140 and inner surface of the cell-separating portion 145.

Thus, the light-scattering layer 150 provided on the upper surface of the second electrode 140 scatters the incident solar ray in all directions, whereby the scattered solar ray is transmitted to the photoelectric conversion portion 130. Simultaneously, the light-scattering layer 150 provided on the inner surface of the cell-separating portion 145 enables to completely insulate the neighboring unit cells divided by the cell-separating portion 145, and enables to scatter the solar ray incident on the lateral sides of the unit cells, to thereby maximize light-capturing efficiency.

Even when the flexible substrate 110 is bent excessively, the neighboring unit cells of the solar cell can be completely insulated from one another owing to the plural beads 155 of insulating material in the cell-separating portion 145.

The incident solar ray can be scattered in all directions through the use of the aforementioned plural beads 155, which will be described as follows.

If a material for the plural beads 155 is different in refractive index from a material for the second electrode 140, the incident solar ray is refracted while passing through the plural beads 155, and is then refracted again while passing through the second electrode 140. As a result, the incident solar ray is refracted in all directions, and is incident on the photoelectric conversion portion 130, whereby the propagation path length of the solar ray is increased in the photoelectric conversion portion 130.

Generally, the refractive index of the second electrode 140 is about 1.9 ∼ 2.0. Since the refractive index of the material for the plural beads 155 has to be different from the refractive index of the material for the second electrode 140, the material for the plural beads 155 is selected in consideration for the aforementioned refractive index of the second electrode 140. For example, the plural beads 155 may be formed of silicon oxide (for example, oxide including silicon elements, that is, SiO₂), or transition metal oxide (for example, oxide including transition metal elements, that is, TiO₂ or CeO₂), but not necessarily.

Instead of forming the bead 155 with the same material, the plurality of beads 155 may be made of the different materials having the different refractive indexes. In this case, the solar ray is refracted at various angles while passing through the plurality of beads 155 made of the different materials having the different refractive indexes.

Each bead 155 includes a core and skin. When the solar ray passes through each bead 155 including the core and skin, the solar ray is refracted at various angles.

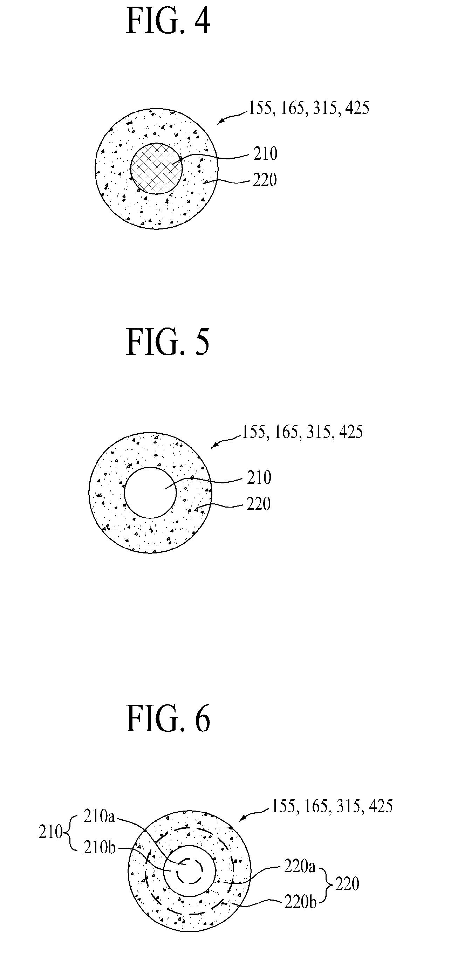

FIGs. 4 to 6 illustrate cross sections of various types of bead 155 according to the embodiments of the present invention.

As shown in FIG. 4, each of the plural beads 155 includes the core 210 and skin 220, wherein the core 210 is surrounded by the skin 220. Also, the material for the core 210 is different in refractive index from the material for the skin 220. Thus, the solar ray is refracted when passing through the core 210 after the skin 220, and is then refracted again when passing through the skin 220 after the core 210.

As shown in FIG. 5, the core 210 in each of the plural beads 155 is formed of air. That is, the hollow-shaped bead 155 is formed by only the skin 220. This structure also enables the same functional effect.

As shown in FIG. 6, the core 210 in each of the plural beads 155 may comprise a plurality of material layers 210a and 210b having the different refractive indexes; and the skin 220 may comprise a plurality of material layers 220a and 220b having the different refractive indexes.

The bead 155 may vary in shape of cross section, for example, circle or oval, whereby the refractive angle of solar ray can be changed diversely.

In the solar cell according to the first embodiment of the present invention, the light-scattering layer 150 including the plural beads 155 is formed on the second electrode 140 corresponding to the light-incidence face, whereby the incident solar ray is scattered at various angles. As a result, the propagation path length of the solar ray is increased in the photoelectric conversion portion 130, to thereby result in improvement of cell efficiency.

In addition, the solar cell according to the first embodiment of the present invention may include a protection film (not shown), and a cover film (not shown). The protection film (not shown) is formed on and adhered to the light-scattering layer 150, to thereby prevent external moisture from being permeated into the second electrode 150. The cover film (not shown) is formed on and adhered to the protection film, to thereby primarily prevent the permeation of external moisture, and to absorb an external shock.

The protection film may be formed of an adhesive sheet such as ethylene vinyl acetate (EVA) or poly vinyl butyral (PVB).

The cover film may be formed of polymer. This cover film may be omitted.

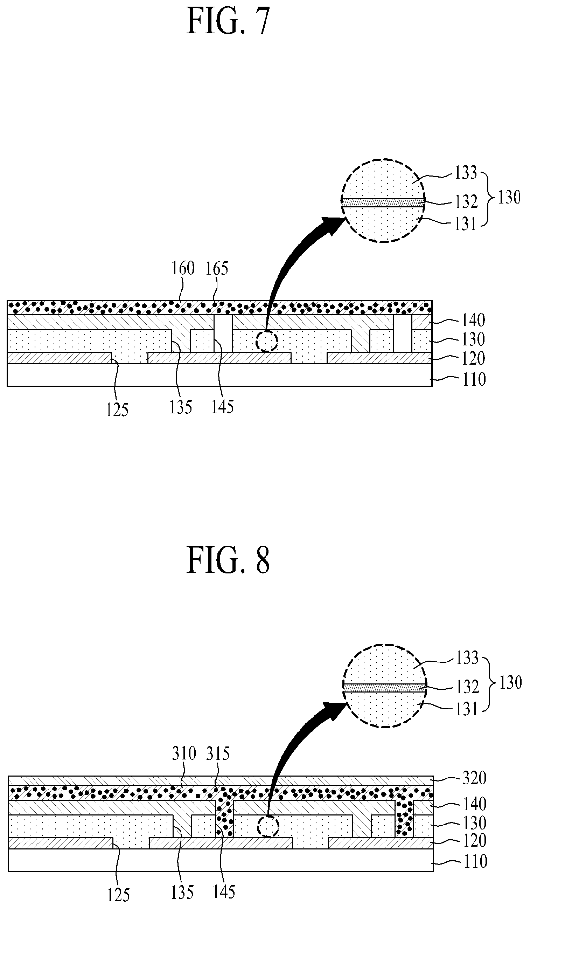

FIG. 7 illustrates a solar cell according to the second embodiment of the present invention.

Referring to FIG. 7, the solar cell according to the second embodiment of the present invention includes a substrate 110, a first electrode 120, an electrode-separating portion 125, a photoelectric conversion portion 130, a contact portion 135, a second electrode 140, a cell-separating portion 145, and a polymer film 160 including plural beads 165. Except the polymer film 160, the solar cell according to the second embodiment of the present invention is identical in structure to the solar cell according to the first embodiment of the present invention. Thus, the same reference numbers will be used throughout the drawings to refer to the same or like parts, and a detailed explanation for the same parts will be omitted.

The plural beads 165are provided inside the polymer film 160, whereby the incident solar ray from the external is scattered at various angles, and is then incident on the photoelectric conversion portion 130. In this case, each of the plural beads 165 may be formed in any shape of FIGs. 4 to 6.

An upper surface or lower surface of the polymer film 160 is coated with the plural beads 165 which make the incident solar ray scattered at various angles and then incident on the photoelectric conversion portion 130. At this time, the plural beads 165 may be formed of silicon oxide (for example, oxide including silicon elements, that is, SiO₂), or transition metal oxide (for example, oxide including transition metal elements, that is, TiO₂ or CeO₂), but not necessarily. In the solar cell according to the second embodiment of the present invention, the plural beads 165 are provided inside the polymer film 160, and on the upper or lower surface of the polymer film 160, whereby the incident solar ray is refracted at various angles. Thus, the propagation path length of the incident solar ray is increased in the photoelectric conversion portion 130, thereby improving the cell efficiency.

FIG. 8 illustrates a solar cell according to the third embodiment of the present invention.

Referring to FIG. 8, the solar cell according to the third embodiment of the present invention includes a substrate 110, a first electrode 120, an electrode-separating portion 125, a photoelectric conversion portion 130, a contact portion 135, a second electrode 140, a cell-separating portion 145, a protection film 310 including plural beads 315, and a cover film 320. Except the protection film 310 and cover film 320, the solar cell according to the third embodiment of the present invention is identical in structure to the aforementioned solar cell according to the first embodiment of the present invention. Thus, the same reference numbers will be used throughout the drawings to refer to the same or like parts, and a detailed explanation for the same parts will be omitted.

The protection film 310 may be formed of an adhesive sheet such as ethylene vinyl acetate (EVA) or poly vinyl butyral (PVB).

The plural beads 315 are provided inside the protection film 310, whereby the incident solar ray from the external is scattered at various angles, and is then incident on the photoelectric conversion portion 130. The plural beads 315 may be formed of silicon oxide (for example, oxide including silicon elements, that is, SiO₂), or transition metal oxide (for example, oxide including transition metal elements, that is, TiO₂ or CeO₂), but not necessarily. In this case, each of the plural beads 165 may be formed in any shape of FIGs. 4 to 6.

An upper surface of the protection film 310 is coated with the plural beads 315 which make the incident solar ray scattered at various angles and then incident on the photoelectric conversion portion 130.

The aforementioned protection film 310 is arranged to cover the second electrode 140 and cell-separating portion 145. Through a lamination process, the protection film 310 is adhered to the second electrode 140, and is inserted into the inside of the cell-separating portion 145, so that it is possible to prevent the external moisture from being permeated into the second electrode 140, and to scatter the solar ray incident on the lateral sides of the unit cells of the solar cell, to thereby maximize light-capturing efficiency. In this case, the neighboring unit cells divided by the cell-separating portions 145 are insulated by the protection film 310 which is inserted into the inside of the cell-separating portion 145 through the aforementioned lamination process.

Even when the flexible substrate 110 is bent excessively, the neighboring unit cells of the solar cell can be completely insulated from one another owing to the protection film 310 in the cell-separating portion 145.

The cover film 320 is formed on an entire surface of the protection film 310, wherein the cover film 320 may be formed of polymer. The cover film 320 primarily prevents the permeation of external moisture, and absorbs the external shock. Occasionally, the cover film 320 may be omitted.

In the solar cell according to the third embodiment of the present invention, the plural beads 315 are provided inside the protection film 310, and on the upper or lower surface of the protection film 310, whereby the incident solar ray is refracted at various angles. Thus, the propagation path length of the incident solar ray is increased in the photoelectric conversion portion 130, thereby improving the cell efficiency.

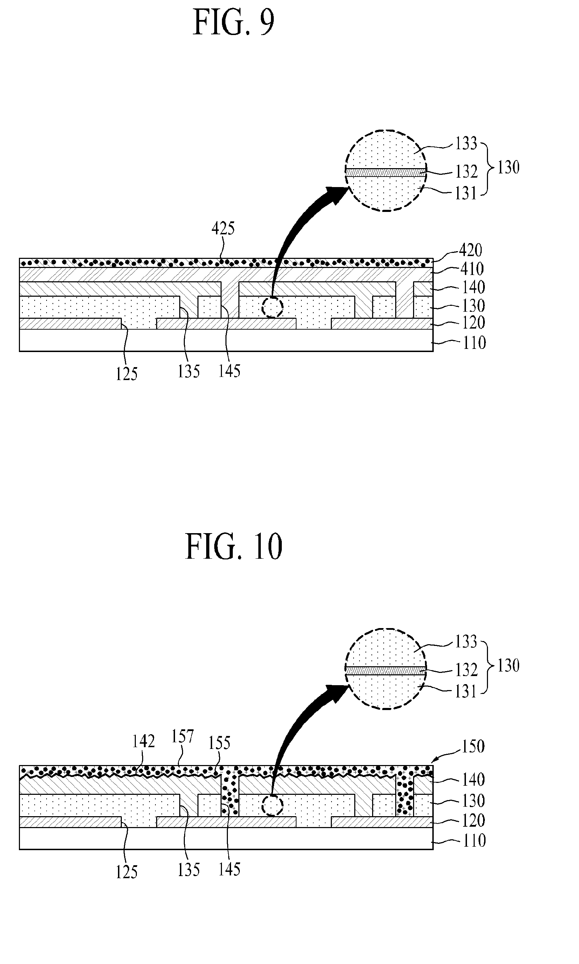

FIG. 9 illustrates a solar cell according to the fourth embodiment of the present invention.

Referring to FIG. 9, the solar cell according to the fourth embodiment of the present invention includes a substrate 110, a first electrode 120, an electrode-separating portion 125, a photoelectric conversion portion 130, a contact portion 135, a second electrode 140, a cell-separating portion 145, a protection film 410, and a cover film 420 including plural beads 425. Except the protection film 410 and cover film 420, the solar cell according to the fourth embodiment of the present invention is identical in structure to the aforementioned solar cell according to the first embodiment of the present invention. Thus, the same reference numbers will be used throughout the drawings to refer to the same or like parts, and a detailed explanation for the same parts will be omitted.

The protection film 410 may be formed of an adhesive sheet such as ethylene vinyl acetate (EVA) or poly vinyl butyral (PVB). The protection film 410 is arranged to cover the second electrode 140 and cell-separating portion 145. Through a lamination process, the protection film 410 is adhered to the second electrode 140, and also the protection film 310 is inserted into the inside of the cell-separating portion 145, so that it is possible to prevent the external moisture from being permeated into the second electrode 140, and to insulate the neighboring unit cells of the solar cell.

The cover film 420 is formed on an entire surface of the protection film 410, wherein the cover film 420 may be formed of polymer. The cover film 420 primarily prevents the permeation of external moisture, and absorbs the external shock.

The plural beads 425 provided inside the cover film 420 make the incident solar ray scattered at various angles and then incident on the photoelectric conversion portion 130. At this time, the plural beads 425 may be formed of silicon oxide (for example, oxide including silicon elements, that is, SiO₂), or transition metal oxide (for example, oxide including transition metal elements, that is, TiO₂ or CeO₂), but not necessarily. In this case, each of the plural beads 425 may be formed in any shape of FIGs. 4 to 6.

Although not shown, the plural beads 425 may be coated between the protection film 410 and the cover film 420, whereby the incident solar ray may be scattered at various angles, and then be incident on the photoelectric conversion portion 130. If the cover film 420 is formed on and adhered to the protection film 410 including the plural beads 425, a surface of the cover film 420 may be provided with irregularities generated by the plural beads 425, whereby the incident solar ray is refracted on the irregularities of the cover film 420, and is then incident on the photoelectric conversion portion 130.

In the solar cell according to the fourth embodiment of the present invention, the plural beads 425 are provided inside the cover film 420, or between the protection film 410 and the cover film 420, whereby the incident solar ray is refracted at various angles. Thus, the propagation path length of the solar ray is increased in the photoelectric conversion portion 130, thereby improving the cell efficiency.

FIG. 10 illustrates a solar cell according to the fifth embodiment of the present invention.

Referring to FIG. 10, the solar cell according to the fifth embodiment of the present invention includes a substrate 110, a first electrode 120, an electrode-separating portion 125, a photoelectric conversion portion 130, a contact portion 135, a second electrode 140, an irregularity structure 142 in an upper surface of the second electrode 140, a cell-separating portion 145, and a light-scattering layer 150. In the solar cell according to the fifth embodiment of the present invention, the irregularity structure 142 is additionally provided in the upper surface of the second electrode 140, and the light-scattering layer 150 is coated on the irregularity structure 142. Except that, the solar cell according to the fifth embodiment of the present invention is identical in structure to the aforementioned solar cell according to the first embodiment of the present invention. Thus, the same reference numbers will be used throughout the drawings to refer to the same or like parts, and a detailed explanation for the same parts will be omitted.

The irregularity structure 142, formed in the upper surface of the second electrode 140, scatters the incident solar ray in all directions, to thereby improve light-capturing efficiency of the photoelectric conversion portion 130.

The irregularity structure 142 may be formed simultaneously with the second electrode 140 by properly adjusting the formation conditions; or may be formed on the second electrode 140 having a flat surface by applying an etching process.

As mentioned in the first embodiment of the present invention, the light-scattering layer 150 may be formed through steps of preparing a paste by uniformly or ununiformly distributing the plural beads 155 in a binder 157; and forming the plural beads 155 on the irregularity structure 142 and in the cell-separating portion 145 by a printing method, a spray-coating method, a sol-gel method, a dip-coating method, or a spin-coating method through the use of the prepared paste.

Preferably, when forming the light-scattering layer 150, the beads 155 are formed through the aforementioned method, and then an additional process of ultraviolet-ray hardening process or low-temperature/high-temperature hardening process is carried out, to thereby enhance an adhesive strength among the beads 155.

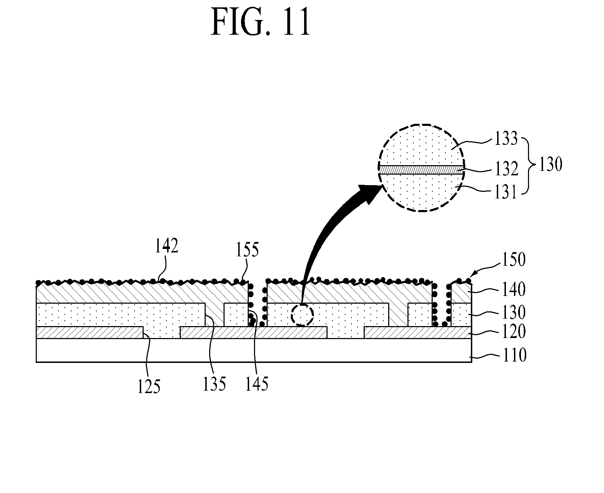

When forming the light-scattering layer 150, the binder 157 enhances the adhesive strength among the plural beads 155 provided on the upper surface of the second electrode 140 and the inner surface of the cell-separating portion 145 through the hardening process, but it is not limited to this. As shown in FIG. 11, the binder 157 may be removed by the hardening process, whereby only the beads 155 may be formed on and adhered to the upper surface of the irregularity structure 142 and inner surface of the cell-separating portion 145.

In the solar cell according to the fifth embodiment of the present invention, the irregularity structure 142 is formed in the upper surface of the second electrode 140 corresponding to a light-incidence face, and the light-scattering layer 150 including the plural beads 155 is formed on the irregularity structure 142, whereby the incident solar ray is refracted at various angles. Thus, the propagation path length of the solar ray is increased in the photoelectric conversion portion 130, thereby improving the cell efficiency.

The irregularity structure 142 in the upper surface of the second electrode 140 of the solar cell according to the fifth embodiment of the present invention can be readily applied to the respective solar cells according to the second to fourth embodiments of the present invention.

### METHOD FOR MANUFACTURING SOLAR CELL

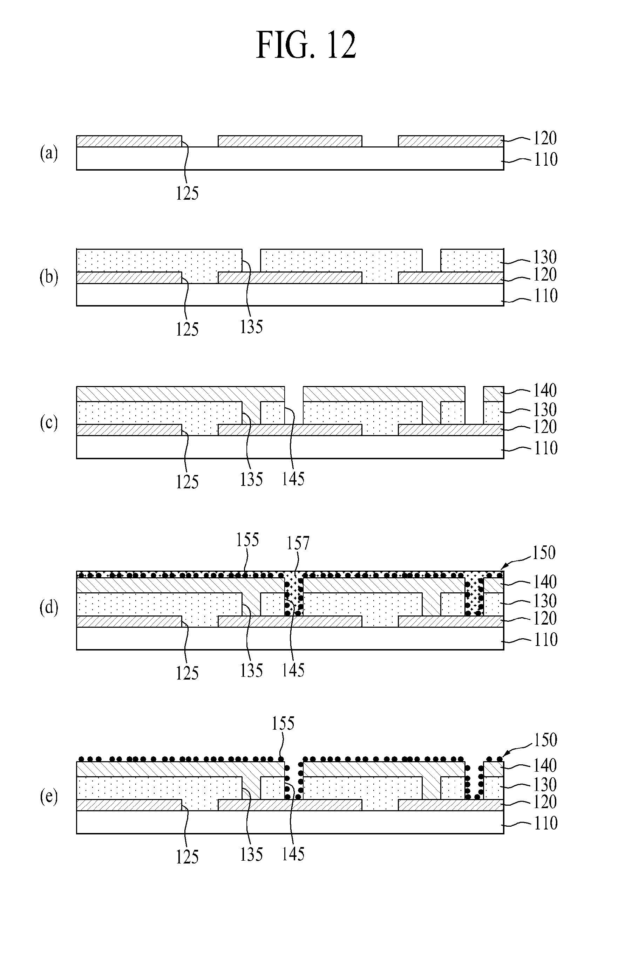

FIG. 12 is a series of cross section views illustrating a method for manufacturing the solar cell according to the first embodiment of the present invention, which is related with the solar cell of FIG. 2 or FIG. 3.

The method for manufacturing the solar cell according to the first embodiment of the present invention will be described with reference to FIG. 12.

First, as shown in FIG. 12(a), the first electrode 120 is formed on the entire surface of the substrate 110, and then predetermined portions are removed from the first electrode 120, to thereby form the electrode-separating portions 125 at fixed intervals.

The substrate 110 may be formed of the flexible substrate, glass, or transparent plastic.

The first electrode 120 may be formed of metal such as Ag, Al, Ag+Mo, Ag+Ni, or Ag+Cu by sputtering or printing.

The electrode-separating portion 125 may be formed by the laser-scribing process.

Then, as shown in FIG. 12(b), the photoelectric conversion portion 130 is formed on the entire surface of the substrate 110 including the first electrode 120 and electrode-separating portion 125. Then, predetermined portions are removed from the photoelectric conversion portion 130 on the first electrode 120, to thereby form the contact portions 135 at fixed intervals.

The photoelectric conversion portion 130 may be formed of silicon-based semiconductor or compound such as CIGS (CuInGaSe2) by a chemical vapor deposition (CVD) method. At this time, the photoelectric conversion portion 130 may be formed in the NIP structure wherein N(negative)-type semiconductor layer, I(intrinsic)-type semiconductor layer, and P(positive)-type semiconductor layer are deposited in sequence. The N-type semiconductor layer indicates the semiconductor layer doped with N-type doping material such as group V elements in the periodic table, for example, stibium (Sb), arsenic (As), and phosphorous (P); the 1-type semiconductor layer indicates an intrinsic semiconductor layer; and the P-type semiconductor layer indicates the semiconductor layer doped with P-type doping material such as group III elements in the periodic table, for example, boron (B), gallium (Ga), and indium (In). Instead of the I-type semiconductor layer, another N-type or P-type semiconductor layer which is relatively thinner than the aforementioned N-type or P-type semiconductor layer may be formed; or another N-type or P-type semiconductor layer whose doping concentration is lower than the aforementioned N-type or P-type semiconductor layer may be formed.

As shown in FIG. 2, the photoelectric conversion portion 130 may be formed in the tandem structure in which the first photoelectric conversion layer 131, the buffer layer 132, and the second photoelectric conversion layer 133 are deposited in sequence.

The photoelectric conversion portion 130 may be formed in the triple structure instead of the tandem structure. In case of the triple structure, each buffer layer is interposed between each of first, second and third semiconductor layers included in the photoelectric conversion portion 130.

The contact portion 135 may be formed of the laser-scribing process.

As shown in FIG. 12(c), the second electrode 140 is formed on the entire surface of the substrate 110 including the photoelectric conversion portion 130 and contact portion 135. Thereafter, predetermined portions are removed from the photoelectric conversion portion 130 and second electrode 140 on the first electrode 120, whereby the cell-separating portion 145 is formed adjacent to the contact portion 135.

The second electrode 140 may be formed of the transparent material, for example, ZnO, ZnO doped with group III elements in the periodic table (for example, ZnO:B, ZnO:Al), ZnO comprising hydrogen elements (for example, ZnO:H), SnO₂, SnO₂:F, or ITO (Indium-Tin-Oxide) by sputtering or MOCVD (Metal Organic Chemical Vapor Deposition).

The cell-separating portion 145 may be formed by the laser-scribing process.

As shown in FIG. 12(d), the light-scattering layer 150 including the plural beads 155 is coated onto the second electrode 140 and cell-separating portion 145.

The light-scattering layer 150 including the plural beads 155 may be formed through steps of preparing the paste by uniformly or ununiformly distributing the beads 155 in the binder 157; and coating the prepared paste on the second electrode 140 and cell-separating portion 145 by the printing method, the sol-gel method, the dip-coating method, or the spin-coating method. At this time, the plural beads 155 may be formed of silicon oxide (for example, oxide including silicon elements, that is, SiO₂), or transition metal oxide (for example, oxide including transition metal elements, that is, TiO₂ or CeO₂), but not necessarily.

Furthermore, the additional process of ultraviolet-ray hardening process or low-temperature/high-temperature hardening process may be carried out to enhance the adhesive strength among the beads 155. In this case, each of the plural beads 155 may be formed in any shape of FIGs. 4 to 6, as explained above.

In the method for manufacturing the solar cell according to the first embodiment of the present invention, as shown in FIG. 12(e), the plural beads 155 may be formed on the upper surface of the second electrode 140 and inner surface of the cell-separating portion 145 by removing the coated binder 157 according to the conditions of the hardening process.

In the method for manufacturing the solar cell according to the first embodiment of the present invention, processes for forming the aforementioned protection film and cover film may be carried out so as to prevent the external moisture from being permeated into the second electrode 140. Occasionally, the process for forming the cover film may be omitted.

If the aforementioned method for manufacturing the solar cell of FIG. 12 is applied to the method for manufacturing the solar cell using the flexible substrate, the process of FIG. 12 (a to e) may be carried out by the roll-to-roll method.

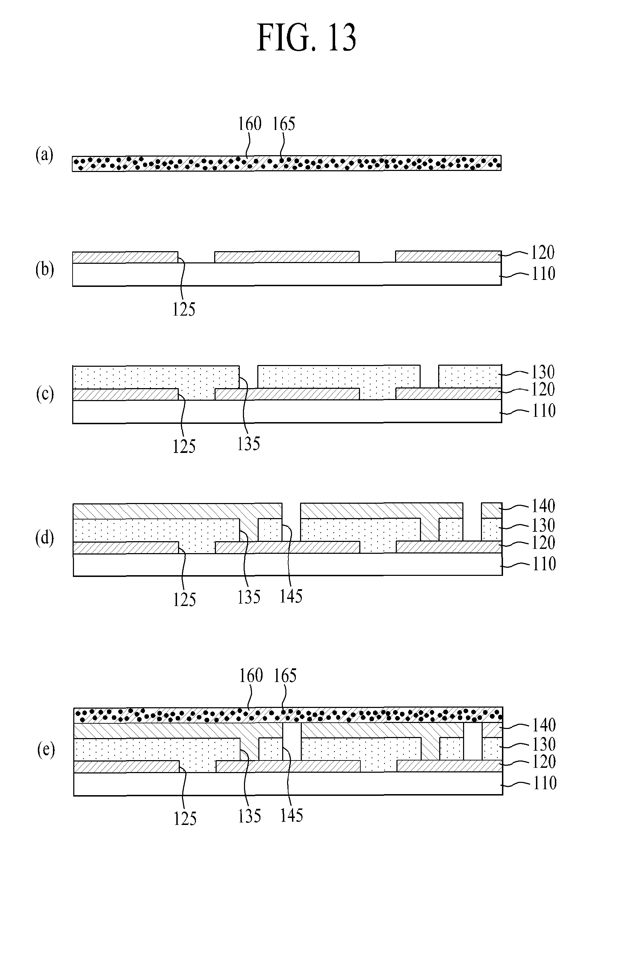

FIG. 13 is a series of cross section views illustrating a method for manufacturing the solar cell according to the second embodiment of the present invention, which is related with the solar cell of FIG. 7. On description of the method for manufacturing the solar cell according to the second embodiment of the present invention, a detailed explanation for the same parts as those of the first embodiment will be omitted.

First, as shown in FIG. 13(a), the polymer film 160 including the plural beads 165 is prepared. At this time, the plural beads 165 may be formed of silicon oxide (for example, oxide including silicon elements, that is, SiO₂), or transition metal oxide (for example, oxide including transition metal elements, that is, TiO₂ or CeO₂), but not necessarily. In this case, each of the plural beads 165 may be formed in any shape of FIGs. 4 to 6.

The plural beads 165 may be coated on the upper or lower surface of the polymer film 160 by the printing method, the spray-coating method, the sol-gel method, the dip-coating method, or the spin-coating method.

Next, as shown in FIG. 13(b), the first electrode 120 is formed on the entire surface of the substrate 110, and then the predetermined portions are removed from the first electrode 120, to thereby form the plural patterns of the first electrode 120 at fixed intervals, and simultaneously the electrode-separating portions 125 at fixed intervals.

As shown in FIG. 13(c), the photoelectric conversion portion 130 is formed on the entire surface of the substrate 110 including the first electrode 120 and the electrode-separating portions 125, and then the predetermined portions are removed from the photoelectric conversion portion 130, to thereby form the contact portions 135 at fixed intervals.

As shown in FIG. 13(d), the second electrode 140 is formed on the entire surface of the substrate 110 including the photoelectric conversion portion 130 and the contact portions 135. Thereafter, predetermined portions are removed from the photoelectric conversion portion 130 and second electrode 140 on the first electrode 120, whereby the cell-separating portion 145 is formed adjacent to the contact portion 135.

As shown in FIG. 13(e), the polymer film 160 including the plural beads 165 is formed on and adhered to the second electrode 140 and cell-separating portion 145.

If the aforementioned method for manufacturing the solar cell of FIG. 13 is applied to the method for manufacturing the solar cell using the flexible substrate, the process of FIG. 13(a to e) may be carried out by the roll-to-roll method.

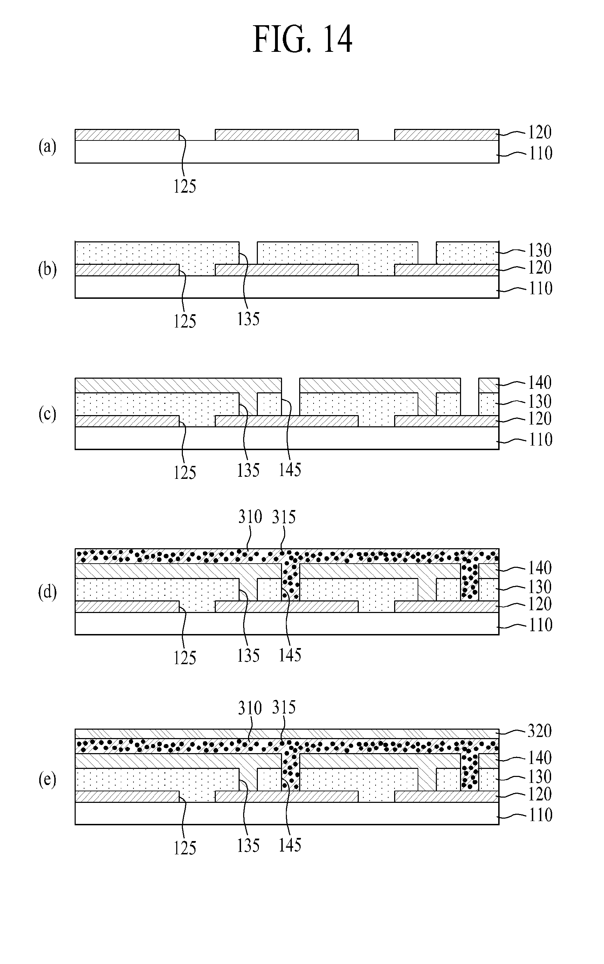

FIG. 14 is a series of cross section views illustrating a method for manufacturing the solar cell according to the third embodiment of the present invention, which is related with the solar cell of FIG. 8. On description of the method for manufacturing the solar cell according to the third embodiment of the present invention, a detailed explanation for the same parts as those of the first embodiment will be omitted.

First, as shown in FIG. 14(a), the first electrode 120 is formed on the entire surface of the substrate 110, and then predetermined portions are removed from the first electrode 120, to thereby form the electrode-separating portions 125 at fixed intervals.

As shown in FIG. 14(b), the photoelectric conversion portion 130 is formed on the entire surface of the substrate 110 including the first electrode 120 and the electrode-separating portion 125. Then, predetermined portions are removed from the photoelectric conversion portion 130 on the first electrode 120, to thereby form the contact portions 135 at fixed intervals.

As shown in FIG. 14(c), the second electrode 140 is formed on the entire surface of the substrate 110 including the photoelectric conversion portion 130 and the contact portions 135. Thereafter, predetermined portions are removed from the photoelectric conversion portion 130 and second electrode 140 on the first electrode 120, whereby the cell-separating portion 145 is formed adjacent to the contact portion 135.

As shown in FIG. 14(d), the protection film 310 including the plural beads 315 is formed on and adhered to the second electrode 140 and cell-separating portion 145. For this, the method for manufacturing the solar cell according to the third embodiment of the present invention further comprises a process for preparing the protection film 310 including the plural beads 315. At this time, each of the plural beads 315 is formed in any shape of FIGs. 4 to 6.

The protection film 310 may be formed of an adhesive sheet such as ethylene vinyl acetate (EVA) or poly vinyl butyral (PVB).

The plural beads 315 may be provided inside the protection film 310. The plural beads 315 may be formed of silicon oxide (for example, oxide including silicon elements, that is, SiO₂), or transition metal oxide (for example, oxide including transition metal elements, that is, TiO₂ or CeO₂), but not necessarily. At this time, each of the plural beads 315 may be formed in any shape of FIGs. 4 to 6.

The plural beads 315 may be coated onto the upper or lower surface of the protection film 310, or may be coated onto the upper surface of the second electrode 140 and the inner surface of the cell-separating portion 145.

The aforementioned protection film 310 is arranged to cover the second electrode 140 and cell-separating portion 145. Through the lamination process, the protection film 310 is adhered to the second electrode 140, and is inserted into the inside of the cell-separating portion 145.

As shown in FIG. 14(e), the cover film 320 of polymer is formed on and adhered to the protection film 310. Occasionally, the adhering process of the cover film 320 may be omitted.

If the aforementioned method for manufacturing the solar cell of FIG. 14 is applied to the method for manufacturing the solar cell using the flexible substrate, the process of FIG. 14 (a to e) may be carried out by the roll-to-roll method.

The aforementioned method for manufacturing the solar cell of FIG. 14 discloses that the protection film 320 including the plural beads 315 is formed on and adhered to the second electrode 140 and cell-separating portion 145. However, it is not limited to this structure. As shown in FIG. 9, the cover film 410 without the plural beads may be firstly formed on the second electrode 140 and cell-separating portion 145, and then the cover film 420 with the plural beads 425 may be formed on the protection film 410. For this, the method for manufacturing the solar cell according to the present invention may further comprise a process for preparing the cover film 420 including the plural beads 425. At this time, each of the plural beads 425 may be formed in any shape of FIGs. 4 to 6.

In another way, the protection film 410 without the plural beads is formed on and adhered to the second electrode 140 and cell-separating portion 145; the plural beads 425 are coated onto the protection film 410; and then the cover film 420 without the plural beads is formed on the protection film 410, whereby the cover film 420 may have the uneven surface based on the shape of the plural beads 425.

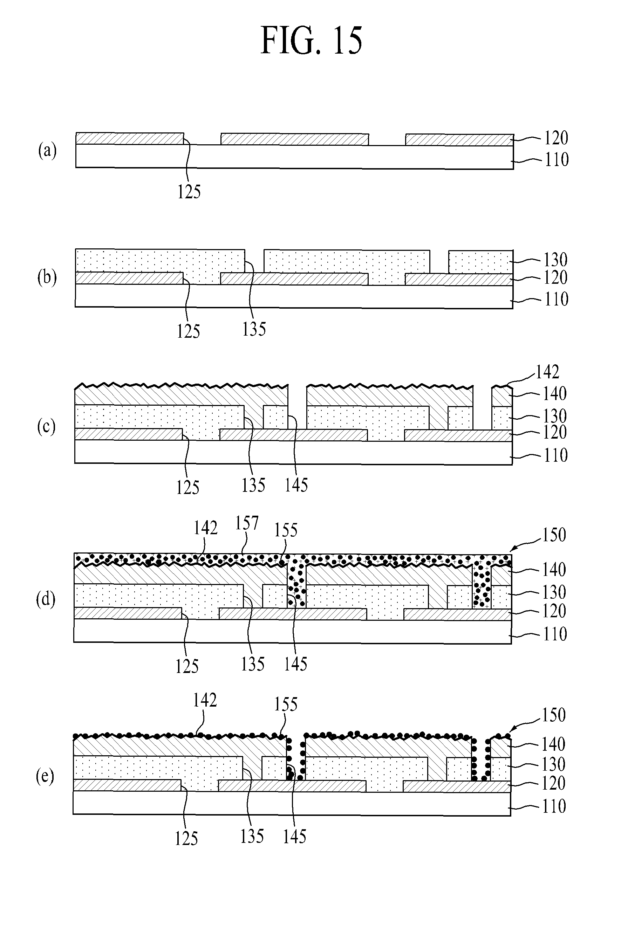

FIG. 15 is a series of cross section view illustrating the solar cell according to the fourth embodiment of the present invention, which is related with the solar cell of FIG. 10 or 11. On description of the method for manufacturing the solar cell according to the fourth embodiment of the present invention, a detailed explanation for the same parts as those of the first embodiment will be omitted.

First, as shown in FIG. 15(a), the first electrode 120 is formed on the entire surface of the substrate 110, and the predetermined portions are removed from the first electrode 120, to thereby form the electrode-separating portions 125 at fixed intervals.

As shown in FIG. 15(b), the photoelectric conversion portion 130 is formed on the entire surface of the substrate 110 including the first electrode 120 and the electrode-separating portion 125. Then, predetermined portions are removed from the photoelectric conversion portion 130 on the first electrode 120, to thereby form the contact portions 135 at fixed intervals.

As shown in FIG. 15(c), the second electrode 140 with the irregularity structure 142 is formed on the entire surface of the substrate 110 including the photoelectric conversion portion 130 and contact portion 135. Thereafter, predetermined portions are removed from the photoelectric conversion portion 130 and second electrode 140 on the first electrode 120, whereby the cell-separating portion 145 is formed adjacent to the contact portion 135.

At this time, the second electrode 140 may be formed of the transparent material, for example, ZnO, ZnO doped with group III elements in the periodic table (for example, ZnO:B, ZnO:Al), ZnO comprising hydrogen elements (for example, ZnO:H), SnO₂, SnO₂:F, or ITO (Indium-Tin-Oxide).

The second electrode 140 with the irregularity structure 142 may be formed by directly forming the second electrode 140 to be provided with the irregularity structure 142 through an adjustment of the deposition conditions for a deposition process of MOCVD (Metal Organic Chemical Vapor Deposition); or may be formed by applying the etching process to the flat surface of the front electrode layer 300 obtained by sputtering. Herein, the etching process may use photolithography, anisotropic etching using a chemical solution, or mechanical scribing.

As shown in FIG. 15(d), the light-scattering layer 150 including the plural beads 155 is coated onto the irregularity structure 142 and cell-separating portion 145.

At this time, the light-scattering layer 150 may be formed through steps of preparing the paste by uniformly or ununiformly distributing the plural beads 155 in the binder 157; and coating the prepared paste onto the irregularity structure 142 and cell-separating portion 145 by the printing method, the sol-gel method, the dip-coating method, or the spin-coating method. Furthermore, the additional process of ultraviolet-ray hardening process or low-temperature/high-temperature hardening process is carried out, to thereby enhance the adhesive strength among the coated beads 155.

In this case, each of the plural beads 155 may be formed in any shape of FIGs. 4 to 6, as explained above.

In the method for manufacturing the solar cell according to the fourth embodiment of the present invention, as shown in FIG. 15(e), the plural beads 155 are formed on the upper surface of the irregularity structure 142 and inner surface of the cell-separating portion 145 by removing the coated binder 157.

In the method for manufacturing the solar cell according to the fourth embodiment of the present invention, a process for adhering the aforementioned protection film 510 to the light-scattering layer 150 may be carried out to prevent the external moisture from being permeated into the second electrode 140; and a process for adhering the cover film 520 to the protection film 510 may be carried out to prevent the external moisture from being permeated into the protection film 510, and simultaneously to absorb the external shock. Occasionally, the process for adhering the cover film 520 to the protection film 510 may be omitted.

If the aforementioned method for manufacturing the solar cell of FIG. 15 is applied to the method for manufacturing the solar cell using the flexible substrate, the process of FIG. 15 (a to e) may be carried out by the roll-to-roll method.

In the method for manufacturing the solar cell according to another embodiment of the present invention, after carrying out the process of FIG. 15 (a to c), the process for adhering the polymer film 160 including the plural beads 165 to the irregularity structure 142 may be carried out as shown in FIG. 7. For this, the process for preparing the polymer film 160 with the plural beads 165 may be additionally carried out, wherein each of the plural beads 165 is formed in any shape of FIGs. 4 to 6.

In the method for manufacturing the solar cell according to another embodiment of the present invention, after carrying out the process of FIG. 15(a to c), the process for adhering the protection film 310 with the plural beads 315 to the irregularity structure 142, and adhering the cover film 320 to the protection film 310 may be carried out as shown in FIG. 8. For this, the process for preparing the protection film 310 with the plural beads 315 may be additionally carried out, wherein each of the plural beads 315 is formed in any shape of FIGs. 4 to 6.

In the method for manufacturing the solar cell according to another embodiment of the present invention, after carrying out the process of FIG. 15(a to c), the process for adhering the protection film 410 without the plural beads to the irregularity structure 142, and adhering the cover film 420 with the plural beads 425 to the protection film 410 may be carried out as shown in FIG. 9. For this, the process for preparing the cover film 420 with the plural beads 425 may be additionally carried out, wherein each of the plural beads 425 is formed in any shape of FIGs. 4 to 6.

In the method for manufacturing the solar cell according to another embodiment of the present invention, after carrying out the process of FIG. 15(a to c), the process for adhering the protection film 510 without the plural beads to the irregularity structure 142, forming the plural beads on the protection film 510, and adhering the cover film 520 without the plural beads to the protection film 510 may be carried out, although not shown.

In the solar cell according to the present invention and the method for manufacturing the same, the plural beads are formed on the second electrode, whereby the incident solar ray can be scattered at various angles. Thus, the propagation path length of the solar ray can be increased in the photoelectric conversion portion, to thereby result in improvement of cell efficiency.

As the plural beads are formed in the cell-separating portion for separating the neighboring unit cells of the solar cell, the solar ray incident on the lateral sides of the unit cell is scattered through the beads of the insulating material, so that it is possible to improve the cell efficiency by maximizing the light-capturing efficiency in the photoelectric conversion portion.

Also, the light-scattering layer or protection film is inserted into the cell-separating portion. Thus, even though the substrate is bent excessively, it is possible to completely insulate the neighboring unit cells of the solar cell.

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

## Claims

1. A solar cell comprising:
a substrate;
a first electrode on the substrate;
a photoelectric conversion portion on the first electrode;
a second electrode on the photoelectric conversion portion; and
plural beads on the second electrode.

2. The solar cell according to claim 1, wherein the plural beads are formed of the different materials having the different refractive indexes.

3. The solar cell according to claim 1, wherein each of the plural beads includes a core and a skin, and the core is surrounded by the skin, and
wherein a material for the core is different in refractive index from a material for the skin.

4. The solar cell according to claim 1, further comprising a cell-separating portion formed by removing predetermined portions of the photoelectric conversion portion and second electrode on the first electrode.

5. The solar cell according to claim 4, wherein the plural beads are provided on the second electrode and inside the cell-separating portion.

6. The solar cell according to 5, further comprising a protection film adhered to the second electrode, and simultaneously inserted into the inside of the cell-separating portion.

7. The solar cell according to claim 4, further comprising a light-scattering layer including the plural beads therein, wherein the light-scattering layer is formed on the second electrode, and is simultaneously inserted into the inside of the cell-separating portion.

8. The solar cell according to claim 4, further comprising a polymer film including the plural beads therein, wherein the polymer film is formed on and adhered to the second electrode and the cell-separating portion.

9. The solar cell according to claim 4, further comprising a protection film including the plural beads therein, wherein the protection film is adhered to the second electrode, and simultaneously inserted into the inside of the cell-separating portion.

10. The solar cell according to claim 9, further comprising a cover film formed on and adhered to the protection film.

11. The solar cell according to claim 4, further comprising:
a protection film adhered to the second electrode and simultaneously inserted into the inside of the cell-separating portion; and
a cover film including the plural beads, wherein the cover film is adhered to the protection film.

12. The solar cell according to claim 4, further comprising:
a protection film adhered to the second electrode and simultaneously inserted into the inside of the cell-separating portion;
a cover film adhered to the protection film; and
the plural beads provided between the protection film and the cover film.

13. The solar cell according to any one of claims 1 to 12, further comprising an irregularity structure in the surface of the second electrode.

14. The solar cell according to claim 1, wherein the substrate is a flexible substrate.

15. A method for manufacturing a solar cell comprising:
forming a first electrode on a substrate;
forming a photoelectric conversion portion on the first electrode;
forming a second electrode on the photoelectric conversion portion; and
forming plural beads on the second electrode.

16. The method according to claim 15, wherein the plural beads are formed of the different materials having the different refractive indexes.

17. The method according to claim 15, wherein each of the plural beads includes a core and a skin, and the core is surrounded by the skin, and
wherein a material for the core is different in refractive index from a material for the skin.

18. The method according to claim 15, further comprising:
forming a cell-separating portion by removing predetermined portions of the photoelectric conversion portion and second electrode on the first electrode,
wherein the process of forming the cell-separating portion is carried out between the process for forming the second electrode and the process for forming the plural beads.

19. The method according to claim 18, wherein the plural beads are provided on the second electrode and inside the cell-separating portion.

20. The method according to claim 18, wherein the process for forming the plural beads comprises:
forming a paste including the plural beads therein on the second electrode and cell-separating portion; and
forming a light-scattering layer provided on the second electrode and simultaneously inserted into the inside of the cell-separating portion by hardening the paste.

21. The method according to claim 18, further comprising forming a polymer film including the plural beads therein,
wherein the process for forming the plural beads further comprises adhering the polymer film to the second electrode and cell-separating portion.

22. The method according to claim 18, further comprising forming a protection film including the plural beads therein,
wherein the process for forming the plural beads further comprises adhering the protection film to the second electrode and cell-separating portion.

23. The method according to claim 22, further comprising forming a cover film on the protection film, wherein the cover film is adhered to the protection film.

24. The method according to claim 18, further comprising:
preparing a cover film including the plural beads therein; and
adhering a protection film to the second electrode and cell-separating portion,
wherein the process for forming the plural beads further comprises adhering the cover film to the protection film.

25. The method according to claim 18, further comprising:
adhering a protection film to the second electrode and cell-separating portion; and
adhering a cover film to the protection film,
wherein the process for forming the plural beads further comprises forming the plural beads between the protection film and the cover film.

26. The method according to any one of claims 15 to 25, further comprising forming an irregularity structure in the surface of the second electrode,
wherein the process for forming the irregularity structure may be carried out simultaneously with the process for forming the second electrode, or may be carried out between the process for forming the second electrode and the process for forming the plural beads.

27. The method according to claim 15, wherein the substrate is a flexible substrate.
